# FASCICULE DE BREVET EUROPEEN

(11) **EP 2 309 560 B1**
(45) Date de publication et mention de la délivrance du brevet: **19.09.2012**
(21) Numéro de dépôt: 10187288.5
(22) Date de dépôt: 12.10.2010
(51) Int. Cl.: H02N 2/18

(54) **Générateur thermoélectrique**
Thermoelektrischer Generator
Thermoelectric Generator

(30) Priorité: 12.10.2009 FR 0957106
(43) Date de publication de la demande: 13.04.2011
(73) Titulaire: STMicroelectronics (Grenoble 2) SAS, 38000 Grenoble (FR)
(72) Inventeur: Descure, Pierrick, 38330 Saint Ismier (FR)
(74) Mandataire: de Beaumont, Michel

(56) Documents cités:
- EP-A2- 1 323 668
- EP-A2- 1 528 609
- US-A- 4 053 859
- US-A- 5 014 036
- US-A1- 2004 150 298

## Description

### Domaine de l'invention

La présente invention concerne un générateur thermoélectrique, c'est-à-dire un dispositif adapté à produire de l'électricité à partir d'une source de chaleur. Elle vise notamment l'exploitation de l'énergie thermique produite par certains équipements, par exemple des boîtiers électroniques ou un pot d'échappement d'une voiture.

### Exposé de l'art antérieur

Dans certains dispositifs mobiles, par exemple des téléphones, des montres, ou des stimulateurs cardiaques, on a proposé d'utiliser des micro-générateurs piézoélectriques pour produire de l'électricité à partir des vibrations mécaniques résultant des mouvements de l'utilisateur. Ceci permet de recharger au moins partiellement les batteries du dispositif. Un inconvénient d'une telle solution est qu'elle ne peut pas être utilisée dans le cas d'un équipement fixe, par exemple un poste de télévision.

On a également proposé des dispositifs adaptés à convertir directement de la chaleur en électricité via l'effet Seebeck. En effet, on a observé qu'il apparaît une différence de potentiel à la jonction de deux matériaux conducteurs soumis à une différence de température. Toutefois, de tels dispositifs ont un rendement très faible. Dans la pratique, l'utilisation de l'effet Seebeck se limite principalement à des applications de mesure de température.

Des dispositifs connus sont divulgués par EP 1 323 668 A2, EP 1 528 609 A2 ou US 2004/0150298 A1.

### Résumé

Ainsi, un objet d'un mode de réalisation de la présente invention est de prévoir un générateur thermoélectrique palliant au moins certains des inconvénients des solutions de l'art antérieur.

Un objet d'un mode de réalisation de la présente invention est de prévoir un tel générateur présentant un rendement élevé.

Un objet d'un mode de réalisation de la présente invention est de prévoir un tel générateur facile à réaliser.

Un objet d'un mode de réalisation de la présente invention est de prévoir un tel générateur facile à intégrer dans des équipements classiques.

Ainsi, un mode de réalisation de la présente invention prévoit un générateur thermoélectrique tel que défini par la revendication 1.

Selon un mode de réalisation de la présente invention, la membrane, dans sa première forme, est adaptée à être en contact avec une paroi chaude et, dans sa seconde forme, est adaptée à être en contact avec une paroi froide.

Selon un mode de réalisation de la présente invention, le générateur comprend en outre un boîtier comprenant des première et seconde parties superposées délimitant une cavité, la membrane étant disposée dans la cavité et fixée au boîtier par ses extrémités latérales, dans lequel la membrane, dans sa première forme, vient en contact avec la première partie du boîtier et, dans sa seconde forme, vient en contact avec la seconde partie du boîtier.

Selon un mode de réalisation de la présente invention, la membrane, dans sa première forme, épouse la face intérieure de la première partie du boîtier et, dans sa seconde forme, épouse la face intérieure de la seconde partie du boîtier.

Selon un mode de réalisation de la présente invention, la membrane comprend une lame de support bimétallique venant s'appuyer à des extrémités latérales sur des ressorts.

Selon un mode de réalisation de la présente invention, la membrane comprend une couche de support en un matériau à mémoire de forme.

Selon un mode de réalisation de la présente invention, le matériau à mémoire de forme est un alliage de nickel et de titane.

Selon un mode de réalisation de la présente invention, l'épaisseur de la couche en un matériau ayant un premier coefficient de dilatation thermique est supérieure à l'épaisseur de la couche piézoélectrique.

Selon un mode de réalisation de la présente invention, le premier coefficient de dilatation thermique est inférieur à celui du matériau piézoélectrique.

Selon un mode de réalisation de la présente invention, le générateur est adapté à être monté sur une puce de circuit intégré.

Selon un mode de réalisation de la présente invention, le générateur est adapté à être monté sur une surface chaude d'une voiture telle qu'un pot d'échappement automobile ou un dispositif de freinage.

Selon un mode de réalisation de la présente invention, le générateur est adapté à être monté dans un chargeur de batterie fonctionnant à partir d'une source de chaleur telle qu'un radiateur ou une plaque de cuisson.

### Brève description des dessins

Ces objets, caractéristiques et avantages, ainsi que d'autres seront exposés en détail dans la description suivante de modes de réalisation particuliers faite à titre non-limitatif en relation avec les figures jointes parmi lesquelles :
la figure 1 est une vue en coupe schématique d'un exemple de réalisation d'un générateur thermoélectrique ;
la figure 2 est une vue en perspective schématique d'une membrane mobile comprise dans le générateur thermoélectrique de la figure 1 ;
la figure 3 est un diagramme illustrant de façon schématique le principe de fonctionnement du générateur thermoélectrique décrit en relation avec les figures 1 et 2 ;
la figure 4 est une vue en coupe schématique d'un exemple de membrane mobile comprise dans un générateur thermoélectrique ;
les figures 5a et 5b sont des vues en coupe schématique illustrant des variantes de réalisation d'une partie de la membrane de la figure 4 ; et
la figure 6 est une vue en coupe schématique d'une variante de réalisation d'un générateur thermoélectrique.

### Description détaillée

Par souci de clarté, de mêmes éléments ont été désignés par de mêmes références aux différentes figures et, de plus, les diverses figures ne sont pas tracées à l'échelle.

Un aspect d'un mode de réalisation de la présente invention est de prévoir un dispositif adapté à :
- convertir de l'énergie thermique en énergie mécanique à l'aide d'une membrane mobile entre deux positions prévue pour changer de forme lorsque sa température varie ; et
- convertir l'énergie mécanique produite par la membrane en énergie électrique.

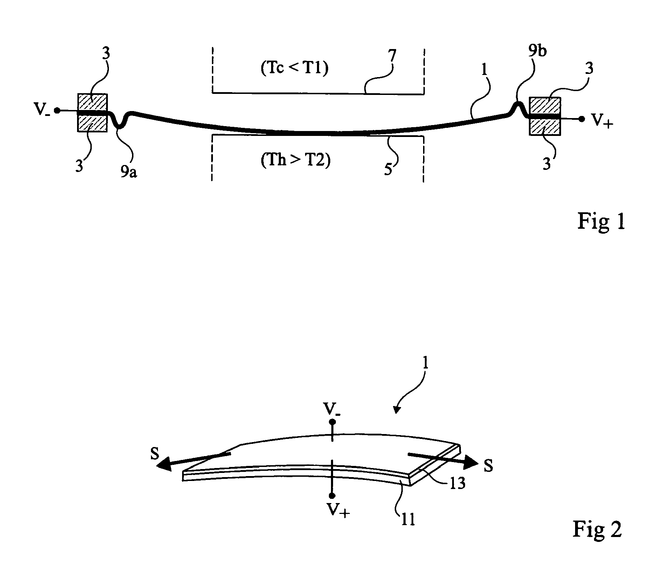

La figure 1 est une vue en coupe schématique d'un exemple de réalisation d'un générateur thermoélectrique. Ce générateur comprend une membrane 1 fixée par ses extrémités latérales à un support 3. Dans cet exemple la membrane 1 a, en vue de dessus, une forme rectangulaire et des dimensions de l'ordre de quelques centimètres de longueur et quelques centimètres de largeur. Toutefois, la membrane peut avoir toute autre forme ou taille. A titre d'exemple, la membrane peut avoir une forme circulaire, le support 3 ayant alors la forme d'une bague.

La membrane 1 est prévue pour alterner entre deux formes lorsque sa température varie. Dans sa première forme, la membrane 1 est incurvée vers le bas, comme cela est représenté en figure 1. Cette première forme correspond à un état de repos, pris par la membrane lorsque sa température est inférieure à un premier seuil T1. Dans sa seconde forme, la membrane est incurvée vers le haut. A titre d'exemple, la seconde forme peut être sensiblement symétrique à la première forme par rapport au plan de symétrie horizontal du support 3. La seconde forme est prise par la membrane lorsque sa température est supérieure à un second seuil T2 supérieur ou égal à T1. On considère ici une membrane fonctionnant selon un cycle d'hystérésis, c'est-à-dire que le second seuil T2 est supérieur au premier seuil T1.

La membrane 1 peut comprendre une couche de support en un matériau à mémoire de forme, par exemple un alliage de nickel et de titane. Un tel matériau comporte deux phases cristallographiques et est capable d'avoir deux positions stables en fonction de sa température.

Selon un autre mode de réalisation, la membrane 1 peut comprendre une lame bimétallique constituée de deux couches superposées de métaux distincts ayant des coefficients de dilatation thermique différents. En raison de la différence de coefficients de dilatation thermique, une telle lame s'incurve dans un sens ou dans l'autre lorsque sa température varie. Toutefois, contrairement au cas d'un matériau à mémoire de forme, la déformation d'une lame bimétallique est progressive, et non pas brutale. Ainsi, pour imposer à la membrane deux formes, tel que décrit ci-dessus, et une transition rapide d'une forme à l'autre, on prévoit des ressorts 9a, 9b, schématisés en figure 1 par la torsion des extrémités latérales de la membrane.

On prévoit de disposer la membrane 1 entre deux parois 5 et 7 en regard l'une de l'autre. La paroi inférieure 5 est une paroi chaude, par exemple une paroi métallique d'un pot d'échappement de voiture ou de freins de voiture, un boîtier d'une puce de circuit intégré, ou toute autre surface chaude d'une puce de circuit intégré ou autre circuit électronique. La paroi supérieure 7 est une paroi froide, c'est-à-dire que sa température est sensiblement inférieure à celle de la paroi chaude. Il peut s'agir d'un radiateur, d'un boîtier externe d'un appareil électronique, ou simplement de l'air ambiant. La disposition est choisie de façon que la membrane vienne, dans sa première forme, en contact avec la paroi chaude 5, et dans sa seconde forme, en contact avec la paroi froide 7.

La figure 2 est une vue en perspective schématique d'une partie de la membrane 1 de la figure 1. Comme cela a été décrit ci-dessus, la membrane 1 comprend une couche de support 11 capable d'alterner entre deux formes en fonction de sa température. A la surface du support 11, il est prévu une couche 13 en un matériau piézoélectrique.

Lorsque la température varie, les changements de forme du support 11 ainsi que les phénomènes de dilatation/compression thermique du support 11 créent des contraintes mécaniques dans la couche piézoélectrique 13. Ces contraintes, représentées sur la figure par les flèches S, s'exercent principalement selon des directions tangentes à la membrane. Dans cet exemple, le matériau piézoélectrique est pré-polarisé de façon que le champ électrique créé dans le matériau soit orthogonal (perpendiculaire à la surface de la membrane) aux contraintes S (tangentielles à la surface de la membrane) s'exerçant sur le matériau. Il en résulte l'apparition d'une différence de potentiel V₊ - V_ entre la face supérieure et la face inférieure de la couche piézoélectrique 13.

On prévoit de former des bornes de contact reliées aux faces supérieure et inférieure de la couche piézoélectrique. Pour cela, on pourra par exemple prévoir une électrode métallique supérieure (non représentée) disposée à la surface de la couche piézoélectrique 13. La couche de support 11 de la membrane étant métallique, elle pourra servir d'électrode inférieure. On peut alors prévoir de former des bornes de sortie du générateur, reliées aux électrodes inférieure et supérieure au niveau des extrémités non mobiles de la membrane, comme cela est représenté en figure 1.

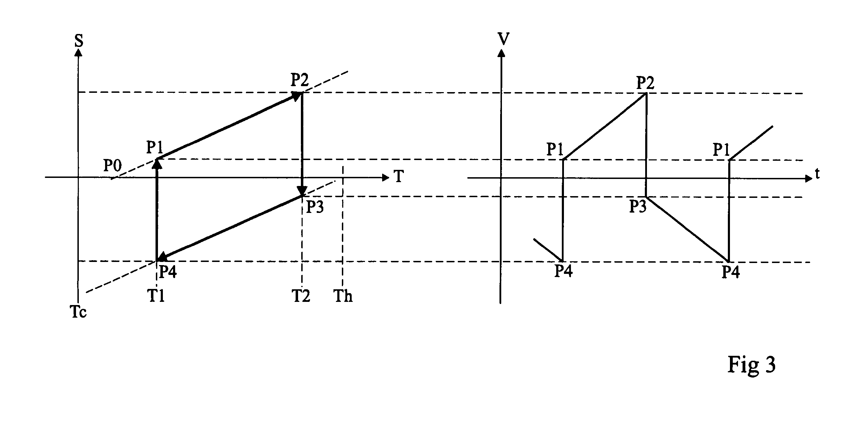

La figure 3 est un diagramme illustrant de façon schématique le principe de fonctionnement du générateur thermoélectrique décrit en relation avec les figures 1 et 2. La partie gauche du diagramme illustre l'évolution des contraintes mécaniques S s'exerçant dans la couche piézoélectrique en fonction de la température T de la membrane. La partie droite du diagramme illustre l'évolution de la tension V aux bornes de sortie du générateur en fonction du temps.

Lors d'une phase initiale P0, la source de chaleur n'est pas établie et la température de la membrane est inférieure à T1. La membrane est alors dans sa première forme, en contact avec la paroi chaude (en ce cas froide) du générateur. Lorsque le système se met à chauffer, la température de la membrane, en contact avec la paroi chaude, augmente progressivement.

On considère par la suite un régime de fonctionnement établi, c'est-à-dire que les parois chaude et froide du générateur thermoélectrique sont à des températures sensiblement constantes, respectivement Th et Tc, avec Tc < T1 < T2 < Th. Le générateur parcourt alors périodiquement un cycle P1-P2-P3-P4.

Au point P1, la température de la membrane est égale au premier seuil, T1, et la membrane est dans sa première forme, en contact avec la paroi chaude. La température de la membrane augmente progressivement, entre les points P1 et P2. Il en résulte une variation progressive des contraintes dans le matériau piézoélectrique, liée à la dilatation de la couche métallique de support de la membrane. Ceci entraine une variation progressive de la tension de sortie du générateur.

Au point P2, la température de la membrane atteint le second seuil, T2, de changement de forme. La membrane prend alors brusquement sa seconde forme, et vient en contact avec la paroi froide du générateur. Il en résulte une brusque variation des contraintes mécaniques dans la couche piézoélectrique, entraînant une brusque variation de la tension aux bornes de sortie du générateur.

Ensuite, à partir du point P3, la température de la membrane, en contact avec la paroi froide, diminue progressivement, entraînant une variation progressive des contraintes dans le matériau piézoélectrique. Il en résulte une variation progressive de la tension aux bornes de sortie du générateur.

Au point P4, la température de la membrane atteint le premier seuil, T1, de changement de forme. La membrane reprend alors brusquement sa première forme, et vient en contact avec la paroi chaude du générateur. Il en résulte une brusque variation des contraintes dans la couche piézoélectrique, entraînant une brusque variation de la tension aux bornes de sortie du générateur. Le cycle recommence alors à partir de la phase P1.

Ainsi, l'énergie thermique de la paroi chaude est transférée par incréments par la membrane vers la paroi froide. Ce transfert entraîne des déplacements de la membrane et des phénomènes de dilatation/compression de la membrane. L'énergie mécanique associée à ces phénomènes est partiellement convertie en énergie électrique.

Un avantage du système proposé est qu'il permet d'utiliser non seulement les contraintes mécaniques liées aux changements de forme de la membrane mais aussi les contraintes mécaniques liées à la dilatation/compression de la membrane pour actionner le matériau piézoélectrique.

Pour optimiser le rendement du générateur, il est souhaitable que la différence de température Th-Tc entre les parois chaude et froide soit maximale. Il est également préférable que l'écart de température entre les seuils T1 et T2 de changement de forme de la membrane soit important. A titre d'exemple, si les températures Th et Tc des parois chaude et froide sont respectivement de 80 et de 30°C, on pourra prévoir une membrane dont les seuils T1 et T2 de changement de forme sont respectivement à 40 et 70°C.

Pour améliorer le contact thermique entre la membrane et les parois chaude et froide, on pourra si nécessaire prévoir un film d'huile ou une pâte thermiquement conductrice sur chacune des parois. De plus, il est préférable que la membrane présente une faible capacité thermique afin de favoriser la fréquence des transferts de chaleur entre la paroi chaude et la paroi froide.

En outre, on choisira de préférence pour réaliser la couche de support de la membrane au moins un matériau présentant un fort coefficient de dilatation thermique.

Par ailleurs, la masse de la membrane (couche de support + couche piézoélectrique) doit être suffisamment faible pour ne pas ralentir ou perturber les déplacements de la membrane. A titre d'exemple, l'épaisseur la couche de support métallique pourra être de l'ordre de 0,5 à 1 mm et celle de la couche piézoélectrique de l'ordre de 0,1 à 0,2 mm.

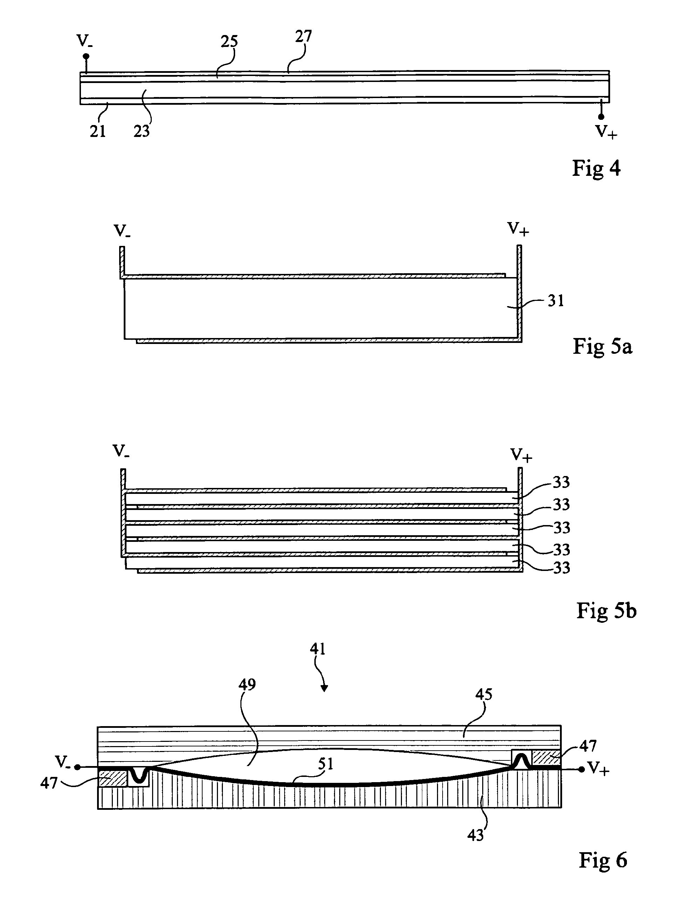

La figure 4 est une vue en coupe schématique d'un mode de réalisation d'une membrane mobile de la présente invention, entre deux positions d'un générateur thermoélectrique du type décrit en relation avec les figures 1 à 3. Dans cet exemple, la membrane comprend un support bimétallique comprenant une couche inférieure 21 d'un premier métal ayant un coefficient de dilatation très faible, par exemple de l'Invar, et une couche supérieure 23 d'un second métal ayant un coefficient de dilatation thermique élevé. Le second métal peut être un matériau à mémoire de forme à fort coefficient de dilatation thermique, par exemple un alliage de nickel et de titane. Si le second métal n'est pas un matériau à mémoire de forme, on pourra prévoir des ressorts latéraux adaptés à assurer le comportement de type hystérésis du cycle thermique. A la surface du support bimétallique, du côté opposé à la couche à faible coefficient de dilatation, il est prévu une couche piézoélectrique 25. Dans cet exemple, la couche piézoélectrique est recouverte d'une électrode métallique 27 adaptée à être connectée à une borne de sortie V- du générateur. La borne de sortie V₊ peut être connectée directement au support bimétallique 21, 23.

Selon un avantage de ce mode de réalisation, le positionnement de la couche piézoélectrique du côté du support bimétallique opposé à la couche invariante 21, permet d'amplifier, dans la couche piézoélectrique, les contraintes mécaniques liées aux phénomènes de dilatation/compression du support métallique.

Dans le cas où la couche 23 est en un matériau à mémoire de forme, lorsque la température augmente, la couche 23 a tendance à se dilater et notamment à s'allonger. En raison de son faible coefficient de dilatation thermique, la couche piézoélectrique tend à s'allonger moins que la couche de support 23. Ainsi, en l'absence de la couche invariante 21, la membrane tend à se courber légèrement pendant la phase d'augmentation progressive de la température. Cette courbure va dans le sens d'une réduction des contraintes s'exerçant dans le matériau piézoélectrique puisqu'elle tend à restreindre l'élongation (forcée par la couche de support) de la couche piézoélectrique. La présence de la couche invariante 21 d'épaisseur supérieure à celle de la couche piézoélectrique et présentant éventuellement un coefficient de dilatation thermique sensiblement inférieur à celui du matériau piézoélectrique empêche ce phénomène de courbure, et au contraire, tend à provoquer une courbure de sens opposé, ce qui produit une forte amplification des contraintes s'exerçant dans la couche piézoélectrique.

Dans le cas où la couche invariante 21 et la couche 23 forment un support bimétallique classique (sans mémoire de forme), forcé en position haute ou basse par des ressorts, lorsque la température augmente, le support bimétallique tend à s'incurver. La couche piézoélectrique présentant un faible coefficient de dilatation thermique, si elle était placée du côté de la couche invariante 21, tendrait à accentuer la courbure du support. Ceci aurait pour effet de restreindre l'élongation (forcée par la dilatation du support) de la couche piézoélectrique, et donc de réduire les contraintes s'exerçant dans le matériau piézoélectrique. Le positionnement de la couche piézoélectrique du côté opposé à la couche invariante empêche ce phénomène de courbure, et au contraire, tend à provoquer une courbure de sens opposé. Ceci produit une forte amplification des contraintes s'exerçant dans la couche piézoélectrique.

Des simulations réalisées par l'inventeur montrent que le mode de réalisation décrit en relation avec la figure 4 permet d'obtenir un rendement de conversion d'énergie thermique en énergie électrique de l'ordre de 15 %.

La figure 5a est une vue en coupe schématique d'une couche piézoélectrique 31 d'un générateur thermoélectrique du type décrit ci-dessus, et de sa connexion aux bornes de sortie V₊ et V- par des électrodes métalliques. Dans cette figure, pour des raisons de clarté, les dimensions verticales sont tout particulièrement agrandies par rapport aux dimensions horizontales.

La figure 5b est une vue en coupe schématique d'une variante de réalisation d'une couche piézoélectrique d'un générateur thermoélectrique du type décrit ci-dessus, et de sa connexion aux bornes de sortie V- et V₊. Dans cette figure, pour des raisons de clarté, les dimensions verticales sont tout particulièrement agrandies par rapport aux dimensions horizontales. Dans cette variante, on prévoit, au lieu d'une couche piézoélectrique épaisse, une pluralité de couches piézoélectriques fines 33 superposées. Des électrodes métalliques, de préférence très fines, relient alternativement les faces avant et arrière des couches piézoélectriques 33 aux bornes de sortie V₊ et V_.

On notera que la tension produite entre les faces avant et arrière d'une couche piézoélectrique est liée à l'épaisseur de cette couche. Ainsi, dans la variante simple-couche de la figure 5a, la couche piézoélectrique, épaisse, produit une tension particulièrement élevée. Un avantage de la variante multi-couche de la figure 5b est qu'elle permet de fournir la même énergie ou puissance électrique qu'avec une structure simple-couche, mais à une tension n fois plus faible, n étant le nombre de couches fines 33, la somme des épaisseurs des couches 33 (figure 5b) étant égale à l'épaisseur de la couche 31 (figure 5a).

La figure 6 est une vue en coupe schématique d'une variante de réalisation d'un générateur thermoélectrique. Le générateur 41 comprend un boîtier ayant par exemple, en vue de dessus, une forme rectangulaire. Le boîtier comprend une partie inférieure 43 adaptée à être mise en contact avec une source de chaleur, et une partie supérieure 45 superposée à la partie inférieure et adaptée à être mise en contact avec une source froide. Les parties 43 et 45 sont de préférence thermiquement conductrices, et sont séparées l'une de l'autre par un matériau thermiquement isolant 47. Les parties 43 et 45 du boîtier délimitent une cavité 49. Dans cet exemple, les faces intérieures des parties 43 et 45 du boîtier ont la forme de cuvettes. Dans la cavité 45, il est prévu une membrane 51 mobile entre deux positions, par exemple du type décrit en relation avec la figure 4. La membrane 51 est fixée au boîtier par ses extrémités latérales. Selon un aspect du présent mode de réalisation, la membrane épouse, dans sa première forme, la face intérieure de la partie chaude 43 du boîtier, et dans sa seconde forme, la face intérieure de la partie froide 45 du boîtier.

Un avantage de ce mode de réalisation est qu'il offre un bon contact thermique entre la membrane et les sources chaudes et froides.

En outre, un tel boîtier est facile à intégrer dans tout dispositif comportant une source de chaleur.

Des modes de réalisation particuliers d'un générateur thermoélectrique ont été décrits. Diverses variantes et modifications apparaîtront à l'homme de l'art.

En particulier, on a décrit un générateur thermoélectrique dans lequel une membrane mobile actionne un élément piézoélectrique ayant la forme d'une couche piézoélectrique déposée directement sur la membrane. On pourra prévoir d'autres dispositions de l'élément piézoélectrique, par exemple des blocs de matériau piézoélectrique sur lesquels viennent s'appuyer les extrémités latérales de la membrane de façon qu'à chaque changement de forme la membrane exerce une pression sur ces blocs.

De façon plus générale, l'homme de l'art saura prévoir d'autres moyens adaptés à convertir l'énergie mécanique de la membrane mobile en énergie électrique.

Par ailleurs, la présente invention ne se limite pas à l'utilisation des sources de chaleur mentionnées ci-dessus pour faire fonctionner le générateur thermoélectrique. Selon une variante de réalisation non représentée, la paroi chaude est directement la face arrière du substrat d'une puce de circuit intégré. Dans cette variante, la membrane vient, dans sa première forme, épouser la face arrière du substrat.

De même, on pourra prévoir un générateur thermoélectrique adapté à recharger des batteries, par exemple des batteries lithium-ion, à partir d'une source de chaleur telle qu'un radiateur ou une plaque de cuisson.

En outre, la présente invention ne se restreint pas aux moyens décrits ci-dessus de connexion de l'élément piézoélectrique aux bornes de sortie du générateur. L'homme de l'art saura mettre en oeuvre tout autre moyen de connexion adapté.

## Revendications

1. Générateur thermoélectrique comprenant :
une membrane (1 ; 51) maintenue par des extrémités latérales et adaptée à prendre une première forme lorsque sa température atteint un premier seuil (T1) et une seconde forme lorsque sa température atteint un second seuil (T2) supérieur au premier seuil, cette membrane comprenant, superposées dans l'ordre suivant, une couche (21) en un matériau ayant un premier coefficient de dilatation thermique, et une couche (23) en un matériau ayant un second coefficient de dilatation thermique nettement supérieur au premier coefficient ; et
une couche en un matériau piézoélectrique (25) déposée sur la membrane et reliée à des bornes de sortie (V₊, V₋) du générateur, pour convertir les mouvements et les déformations de la membrane en électricité, la couche piézoélectrique (25) étant disposée du côté de la couche (23) de second coefficient.

2. Générateur selon la revendication 1, dans lequel la membrane, dans sa première forme, est adaptée à être en contact avec une paroi chaude (5) et, dans sa seconde forme, est adaptée à être en contact avec une paroi froide (7).

3. Générateur selon la revendication 1 ou 2, comprenant en outre un boîtier comprenant des première (43) et seconde (45) parties superposées délimitant une cavité (49), la membrane (51) étant disposée dans la cavité et fixée au boîtier par lesdites extrémités latérales, dans lequel la membrane, dans sa première forme, vient en contact avec la première partie du boîtier et, dans sa seconde forme, vient en contact avec la seconde partie du boîtier.

4. Générateur selon la revendication 3, dans lequel la membrane, dans sa première forme, épouse la face intérieure de la première partie du boîtier (43) et, dans sa seconde forme, épouse la face intérieure de la seconde partie du boîtier (45).

5. Générateur selon l'une quelconque des revendications 1 à 4, dans lequel la membrane comprend une lame de support bimétallique venant s'appuyer à des extrémités latérales sur des ressorts (9a, 9b).

6. Générateur selon l'une quelconque des revendications 1 à 5, dans lequel la membrane comprend une couche de support en un matériau à mémoire de forme.

7. Générateur selon la revendication 6, dans laquelle le matériau à mémoire de forme est un alliage de nickel et de titane.

8. Générateur selon l'une quelconque des revendications 1 à 7, dans lequel l'épaisseur de la couche (21) en un matériau ayant un premier coefficient de dilatation thermique est supérieure à l'épaisseur de la couche piézoélectrique (25).

9. Générateur selon l'une quelconque des revendications 1 à 8, dans lequel le premier coefficient de dilatation thermique est inférieur à celui du matériau piézoélectrique.

10. Générateur selon l'une quelconque des revendications 1 à 9, adapté à être monté sur une puce de circuit intégré.

11. Générateur selon l'une quelconque des revendications 1 à 9, adapté à être monté sur une surface chaude d'une voiture telle qu'un pot d'échappement automobile ou un dispositif de freinage.

12. Générateur selon l'une quelconque des revendications 1 à 9, adapté à être monté dans un chargeur de batterie fonctionnant à partir d'une source de chaleur telle qu'un radiateur ou une plaque de cuisson.

## Claims

1. A thermoelectric generator comprising:
a membrane (1; 51) maintained by lateral ends and capable of taking a first shape when its temperature reaches a first threshold (T1) and a second shape when its temperature reaches a second threshold (T2) greater than the first threshold said membrane comprising, superposed in the following order, a layer (21) of a material having a first thermal expansion coefficient, and a layer (23) of a material having a second thermal expansion coefficient much greater than the first coefficient; and
a piezoelectric layer (25) deposited on the membrane and connected to output terminals (V₊, V₋) of the generator to convert the motions and the deformations of the membrane into electricity, the piezoelectric layer (25) being disposed on the side of the layer (23) having the second coefficient.

2. The generator of claim 1, wherein the membrane, in its first shape, is adapted to be in contact with a hot wall (5) and, in its second shape, is adapted to be in contact with a cold wall (7).

3. The generator of claim 1, further comprising a package comprising first (43) and second (45) superposed portions delimiting a cavity (49), the membrane (51) being arranged in the cavity and attached to the package by said lateral ends, wherein the membrane, in its first shape, comes in contact with the first portion of the package and, in its second shape, comes in contact with the second portion of the package.

4. The generator of claim 3, wherein the membrane, in its first shape, takes the shape of the inner surface of the first portion of the package (43) and, in its second shape, takes the shape of the inner portion of the second portion of the package (45).

5. The generator of any of claims 1 to 4, wherein the membrane comprises a bimetallic support strip bearing against lateral ends on springs (9a, 9b).

6. The generator of any of claims 1 to 5, wherein the membrane comprises a support layer made of a shape-memory material.

7. The generator of claim 6, wherein the shape-memory material is a nickel and titanium alloy.

8. The generator of any of claims 1 to 7, wherein the thickness of the layer (21) of a material having a first thermal expansion coefficient is greater than the thickness of the piezoelectric layer (25).

9. The generator of any of claims 1 to 8, wherein the first thermal expansion coefficient is smaller than that of the piezoelectric material.

10. The generator of any of claims 1 to 9, adapted to be assembled on an integrated circuit chip.

11. The generator of any of claims 1 to 9, adapted to be assembled on a hot surface of a car such as a car silencer or a braking device.

12. The generator of any of claims 1 to 9, adapted to be assembled in a battery charger operating from a heat source such as a heater or a cooking plate.

## Patentansprüche

1. Ein thermoelektrischer Generator, der Folgendes aufweist:
eine Membran (1; 51), die von lateralen Enden gehalten wird und geeignet ist eine erste Form anzunehmen, wenn ihre Temperatur eine erste Schwelle (T1) erreicht und eine zweite Form anzunehmen, wenn ihre Temperatur eine zweite Schwelle (T2) erreicht, die höher ist als die erste Schwelle, wobei die Membran Folgendes, in der folgenden Reihenfolge überlagert, aufweist:
eine Lage (21) eines Materials mit einem ersten thermischen Ausdehnungskoeffizienten und eine Lage (23) eines Materials mit einem zweiten thermischen Ausdehnungskoeffizienten, der sehr viel größer ist als der erste Koeffizient; und
eine piezoelektrische Lage (25), die auf der Membran aufgebracht ist und mit Ausgangsanschlüssen (V+, V-) des Generators verbunden ist, um die Bewegung und die Deformation der Membran in Elektrizität umzuwandeln, wobei die piezoelektrische Lage (25) an der Seite der Lage (23) angeordnet ist, die den zweiten Koeffizienten aufweist.

2. Der Generator nach Anspruch 1, wobei die Membran in ihrer ersten Form geeignet ist mit einer heißen Wand (5) in Verbindung zu stehen und in ihrer zweiten Form geeignet ist mit einer kalten Wand (7) in Verbindung zu stehen.

3. Der Generator nach Anspruch 1, wobei der Generator ferner Folgendes aufweist: eine Einheit, die erste (43) und zweite (45) überlagerte Teile aufweist, die einen Raum beziehungsweise eine Kavität (49) begrenzen, wobei die Membran (51) in der Kavität angeordnet ist und an der Einheit über die lateralen Enden angebracht ist, wobei die Membran in ihrer ersten Form in Kontakt mit dem ersten Teil der Einheit kommt und in ihrer zweiten Form mit dem zweiten Teil der Einheit in Kontakt kommt.

4. Der Generator nach Anspruch 3, wobei die Membran in ihrer ersten Form die Form der inneren Fläche des ersten Teils der Einheit (43) annimmt und in ihrer zweiten Form die Form des inneren Teils des zweiten Teils der Einheit (45) annimmt.

5. Der Generator nach einem der Ansprüche 1 bis 4, wobei die Membran einen Bimetallträgerstreifen aufweist, der sich gegen laterale Enden auf Federn (9a, 9b) abstützt.

6. Der Generator nach einem der Ansprüche 1 bis 5, wobei die Membran eine Trägerschicht aufweist, die aus einem Formgedächtnismaterial besteht.

7. Der Generator nach Anspruch 6, wobei das Formgedächtnismaterial eine Nickel-Titanlegierung ist.

8. Der Generator nach einem der Ansprüche 1 bis 7, wobei die Dicke der Lage (21) eines Materials mit einem ersten thermischen Ausdehnungskoeffizienten größer ist als die Dicke der piezoelektrischen Lage (25).

9. Der Generator nach einem der Ansprüche 1 bis 8, wobei der erste thermische Ausdehnungskoeffizient kleiner ist als der des piezoelektrischen Materials.

10. Der Generator nach einem der Ansprüche 1 bis 9, wobei der Generator geeignet ist auf einem integrierten Schaltkreischip aufgebaut zu sein.

11. Der Generator nach einem der Ansprüche 1 bis 9, wobei der Generator geeignet ist auf einer heißen Oberfläche eines Autos, wie zum Beispiel eines Schalldämpfers oder einer Bremsvorrichtung, aufgebaut zu sein.

12. Der Generator nach einem der Ansprüche 1 bis 9, wobei der Generator geeignet ist in einem Batterieladegerät aufgebaut zu sein, das von einer Wärmequelle, wie zum Beispiel eines Heizelements oder einer Kochplatte, betrieben wird.
